# EUROPÄISCHE PATENTSCHRIFT

(11) **EP 3 218 274 B1**
(45) Veröffentlichungstag und Bekanntmachung des Hinweises auf die Patenterteilung: **21.11.2018**
(21) Anmeldenummer: 15766429.3
(22) Anmeldetag: 10.09.2015
(51) Int. Cl.: B65D 5/42

(54) **VORRICHTUNG ZUR ÖFFNUNGSSENSIERUNG EINER VERPACKUNG SOWIE VERFAHREN ZUR HERSTELLUNG DER VORRICHTUNG**
DEVICE FOR CHECKING WHETHER A PACKAGE HAS BEEN OPENED OR NOT AND METHOD FOR PRODUCING SAID DEVICE
DISPOSITIF DE DÉTECTION D'OUVERTURE D'EMBALLAGE ET PROCÉDÉ DE PRODUCTION DUDIT DISPOSITIF

(30) Priorität: 14.11.2014 DE 102014223256
(43) Veröffentlichungstag der Anmeldung: 20.09.2017
(73) Patentinhaber: Robert Bosch GmbH, 70442 Stuttgart (DE)
(72) Erfinder: KUGLER, Andreas, 73553 Alfdorf (DE); WOEHR, Sandra, 71277 Rutesheim (DE); WIEDUWILT, Ulrich, 73529 Schwaebisch Gmuend (DE); MAHLICH, Matthias, 70736 Fellbach (DE); HANISCH, Markus, 70736 Fellbach (DE); MUELLER, Markus, 71334 Waiblingen (DE); OBERDORFER, Berend, 72793 Pfullingen (DE)
(86) Internationale Anmeldenummer: PCT/EP2015/070684
(87) Internationale Veröffentlichungsnummer: WO 2016/074823

(56) Entgegenhaltungen:
- WO-A1-2006/064523
- WO-A1-2006/101651
- DE-U1- 20 115 621

## Beschreibung

Die Erfindung geht aus von einer Vorrichtung zur Öffnungssensierung einer Verpackung sowie ein Verfahren zur Herstellung der Vorrichtung nach der Gattung der unabhängigen Ansprüche. Eine Vorrichtung ist bereits aus der DE 603 04 601 T2 offenbart. Hierbei umfasst ein elektronisches Manipulationserfassungssystem eine entsprechende Elektronik, die das Öffnen insbesondere einer Faltschachtel erkennt. Hierzu sind Verschlussklappen mit elektrisch leitendem Klebstoff versehen. Eine Trennung der Klappen unterbricht einen elektrischen Kreis, welcher eine Elektronik umfasst, die die Unterbrechung zusammen mit einem Zeitstempel in einen Datenspeicher der Elektronik aufzeichnet. Aus der WO 2006/064523 A1 ist eine gattungsgemäße manipulationssichere Verpackung offenbart, die einen Sensor enthält, der in der Lage ist, abhängig vom Zustand einer geöffneten oder geschlossenen Lasche seinen Zustand zu ändern. Dies kann zur Erzeugung eines Signals verwendet werden, das angibt, ob die Verpackung geöffnet wurde. Die Öffnungssensierung erfolgt über das Detektieren eines Öffnens bzw. Schließens eines Stromkreises, der über die Kontaktpunkte und eine flächige Leiterbahn, die an einer Lasche angeordnet ist, gebildet wird.

Es ist Aufgabe der Erfindung, die gattungsgemäße Vorrichtung weiter zu vereinfachen. Diese Aufgabe wird gelöst durch die Merkmale der unabhängigen Ansprüche.

### Vorteile der Erfindung

Die erfindungsgemäße Vorrichtung zur Sensierung einer Verpackung hat demgegenüber den Vorteil, dass sich die Verpackung leichter fertigen lässt. Dies wird erfindungsgemäß dadurch erreicht, dass als Mittel zur Öffnungssensierung der Verpackung zumindest ein Dehnungssensor vorgesehen ist. Dadurch kann auf die Verwendung von Leitkleber verzichtet werden. Dadurch verbilligt sich die Herstellung einer entsprechenden Verpackung.

In einer zweckmäßigen Weiterbildung ist das Mittel zur Öffnungssensierung und/oder die Batterie und/oder die Anzeige und/oder zumindest eine Leiterbahn aufgedruckt auf einem Trägermaterial. Damit lässt sich eine besonders einfache und kostengünstige Herstellung erreichen, die zudem auf ähnliche Technologien bei der Verpackungsherstellung wie das übliche Bedrucken zurückgreift. Dadurch kann das Handling des Trägermaterials bzw. Zuschnitts beibehalten werden.

In einer zweckmäßigen Weiterbildung wird bei einer Öffnungssensierung einer Verpackung zumindest ein Impuls generiert, den die Elektronik zur Öffnungssensierung auswertet, und/oder über den eine Kapazität geladen wird. Dadurch lassen sich besonders einfach lediglich Änderungen eines Zustands überwachen.

In einer zweckmäßigen Weiterbildung sind die Mittel zur Öffnungssensierung auf der Innenseite der Verpackung aufgebracht. Damit sind diese Mittel zusammen mit zumindest der zugehörigen Elektronik und Batterie für den Verbraucher nicht sichtbar bzw. müssen daher auch nicht zusätzlich maskiert werden. Dadurch vereinfacht sich der Herstellungsprozess weiter. Diese Anordnung an der Innenseite ist bevorzugt zusammen mit dem Dehnungssensor zu bewerkstelligen, der trotz innenliegender Anordnung dennoch eine Sensierung einer von einem Öffnungsvorgang herrührenden Dehnung sicher erfasst.

In einer zweckmäßigen Weiterbildung wird abhängig von einer Öffnungssensierung der Verpackung ein Timer und/oder die Anzeige und/oder eine Erfassung einer Information eines Sensors und/oder ein Funkmodul aktiviert. Damit könnte beispielsweise der Zeitpunkt des Öffnens erfasst und über Anzeige oder Funk mitgeteilt werden. Auch das Starten eines Timers ist besonders vorteilhaft, da auf diese einfache Art und Weise eine Überwachung der Haltbarkeit möglich ist. Besonders in der Lebensmittelindustrie kann dadurch der Abfall von Lebensmitteln deutlich reduziert werden.

In einer zweckmäßigen Weiterbildung ist zumindest ein Bedienelement vorgesehen zur Beeinflussung der Anzeige und/oder zumindest eines Funkmoduls und/oder zumindest eines Timers und/oder zumindest eines Sensors zur Ermittlung einer Temperatur und/oder eines Drucks, insbesondere Luftdrucks, und/oder einer Beschleunigung und/oder einer Erschütterung und/oder eines Gases eines verpackten Lebensmittels. In besonders einfacher Weise kann ein Verbraucher oder Verkäufer oder sonstige Person zum gewünschten Zeitpunkt Informationen abrufen und in geeigneter Weise übermittelt bekommen.

Das erfindungsgemäße Verfahren zur Herstellung einer Vorrichtung gemäß den Merkmalen des unabhängigen Verfahrensanspruchs hat demgegenüber den Vorteil, dass eine einfache Herstellung mit für die Verpackungsherstellung üblichen Technologien möglich wird. Insbesondere die Zuführungen oder ähnliches können beibehalten werden und besonders einfach in den Herstellprozess aufgrund ähnlicher Technologie integriert werden.

In einer zweckmäßigen Weiterbildung ist ein Timer vorgesehen. Dieser wird bevorzugt abhängig von einer Öffnungssensierung der Verpackung aktiviert. Bei

Ablauf des Timers stellt die Elektronik eine bestimmte Information wie beispielsweise der Ablauf der Mindesthaltbarkeitsdauer oder das baldige Ende der Mindesthaltbarkeitsdauer oder ähnliches dem Verbraucher zur Verfügung. Besonders bevorzugt wird hierzu die Anzeige entsprechend ansteuert.

In einer zweckmäßigen Weiterbildung wird bei Ablauf des Timers zumindest eine Information, insbesondere betreffend eines in der Verpackung befindlichen Produkts, durch ein Funkmodul versendet. Der Benutzer kann diese Information auf beliebigen Geräten wie Smartphone, Computer oder ähnliches abrufen und wird auf besonders einfache Art sicher informiert.

In einer zweckmäßigen Weiterbildung sind mehrere Timer (multi-timer) vorgesehen, bei deren Ablauf unterschiedliche Informationen, zur Anzeige gelangen bzw. über das Funkmodul gesendet werden können. Damit kann auf das baldige Ablaufen des Produkts in zeitlich gestaffelter Weise hingewiesen werden.

In einer zweckmäßigen Weiterbildung ist zumindest ein Bedienelement vorgesehen. Dadurch kann die Verpackung nutzerfreundlich gewünschte Informationen zur Verfügung stellen kann.

In einer zweckmäßigen Weiterbildung ist vorgesehen, dass das Bedienelement mit der Elektronik verbunden ist zur Erkennung einer oder mehrerer Betätigung(en) des Bedienelements. Die ohnehin schon zur Ansteuerung der Anzeige vorgesehene Elektronik wird nun auch für die Auswertung des Bedienelements vorgesehen, weshalb sich der Aufwand für die Gesamtanordnung nicht wesentlich erhöht.

In einer zweckmäßigen Weiterbildung ist vorgesehen, dass das Bedienelement mit der Elektronik verbunden ist zur Erkennung einer Dauer einer oder mehrerer Betätigung(en) des Bedienelements. Mit nur einem Bedienelement können dadurch unterschiedliche Bedienbefehle realisiert werden, ohne auf weitere Hardware zurückgreifen zu müssen.

In einer zweckmäßigen Weiterbildung ist vorgesehen, dass abhängig von der jeweiligen Betätigung oder der Dauer der jeweiligen Betätigung in der Elektronik unterschiedliche Datensätze und/oder Befehle hinterlegt sind. Damit können unterschiedliche Informationen angezeigt werden, eine Auswahl getroffen werden, ob die Anzeige oder über Funk Daten übermittelt werden sollen. Auch könnten weitere Funktionen wie das Starten eines Timers, das Auslesen von Sensordaten oder ähnliches in besonders flexibler Weise vorgenommen werden. In einer zweckmäßigen Weiterbildung ist vorgesehen, dass abhängig von der jeweiligen Betätigung des Bedienelements oder der Dauer der jeweiligen Betätigung des Bedienelements in der Elektronik unterschiedliche Ansteuerungen für die Anzeige und/oder das Funkmodul und/oder der Elektronik und/oder des Timers und/oder des Sensors vorgesehen sind. Dies erhöht die Bedienerfreundlichkeit der Vorrichtung.

In einer zweckmäßigen Weiterbildung ist vorgesehen, dass bei Betätigung des Bedienelements von dem Sensor ermittelte Daten zur Anzeige und/oder über das Funkmodul ausgegeben werden. Damit kann bei Bedarf eine genaue Information über die Umgebungsbedingungen der Verpackung bzw. des Produkts eingeholt werden.

In einer zweckmäßigen Weiterbildung ist vorgesehen, dass zumindest ein weiteres Bedienelement vorgesehen ist. Dadurch können in schneller Weise eine große Anzahl unterschiedlicher Befehle eingegeben werden.

In einer zweckmäßigen Weiterbildung ist vorgesehen, dass die Elektronik zumindest ein Schaltmittel, vorzugsweise einen Transistor, umfasst, das abhängig von einer Betätigung des Bedienelements die Anzeige ansteuert. Damit lässt sich mit einer einfachen Schaltung eine Anzeige steuern.

In einer zweckmäßigen Weiterbildung ist ein Sensor vorgesehen zur Ermittlung vorzugsweise einer Temperatur und/oder eines Drucks, insbesondere Luftdruck, und/oder einer Kraft und/oder einer Beschleunigung und/oder einer Erschütterung und/oder eines Gases. Dadurch können zusätzliche Informationen die Verpackung und/oder das verpackte Produkt betreffend individuell erzeugt und zur Verfügung gestellt werden. Damit lassen sich interessierende Daten im Laufe unterschiedlicher Bearbeitungsschritte von der Herstellung, der Verpackung, des Transports, Bereitstellen im Laden bis zum Verkauf für die jeweilige Verpackung bzw. Produkt etc. zuverlässig erfassen. Dies ist für die Qualitätskontrolle bis hin zur Anzeige relevanter Informationen für den Verbraucher von Vorteil.

In einer zweckmäßigen Weiterbildung steuert die Elektronik abhängig von einer Betätigung des Bedienelements und/oder eines von dem Funkmodul übertragenen Befehls den Sensor zur Erfassung von Daten ansteuert. Damit lassen sich die Daten zu gewünschten Zeitpunkten wie beispielsweise beim Einräumen in die Verkaufsflächen oder bei einer Eingangskontrolle gezielt abfragen. Auch kann eine Überprüfung automatisch erfolgen, wenn über Funk die entsprechenden Befehle an die in Reichweite befindlichen Verpackungen gesendet werden.

In einer zweckmäßigen Weiterbildung ist vorgesehen, dass die Elektronik die von dem Sensor ermittelten Daten mit einem Grenzwert vergleicht. Besonders zweckmäßig generiert die Elektronik bei Über- oder Unterschreiten des Grenzwerts zumindest eine zugehörige Meldung. Damit ist die Verpackung mit entsprechender Auswerteintelligenz ausgestattet, so dass einsprechende Meldungen ohne Auswertung in einem zentralen Rechner unmittelbar angezeigt werden können. Besonders zweckmäßig gibt hierzu die Elektronik bei Über- oder Unterschreiten des Grenzwerts die Daten des Sensors und/oder die zugehörige Meldung über die Anzeige und/oder das Funkmodul aus.

In einer zweckmäßigen Weiterbildung ist vorgesehen, dass die Elektronik bei einem Öffnen der Verpackung und/oder bei Betätigung des Bedienelements und/oder Ablauf des Timers und/oder eines von dem Funkmodul übertragenen Befehls die Daten des Sensors und/oder die zugehörige Meldung über die Anzeige und/oder das Funkmodul ausgibt. Dann kann der Benutzer die aktuellen Daten zum gewünschten Zeitpunkt erhalten beispielsweise bei einer Endkontrolle, bei Anlieferung der mit der Verpackung verpackten Produkte oder vor dem Einräumen im Laden bzw. beim Öffnen der Verpackung.

In einer zweckmäßigen Weiterbildung ist vorgesehen, dass die Elektronik einen Ablauf des Timers verändert in Abhängigkeit von den vom Sensor ermittelten Daten. Damit wird produkt- bzw. verpackungsindividuell eine spezielle Überwachung ermöglicht. Beispielsweise bei höheren Temperaturen ist eine geringere Haltbarkeit des verpackten Produkts zu erwarten, so dass der Timer mit einer geringeren Zeitspanne gestartet wird. Oder erfasst der Sensor bereits einen erhöhten bzw. kritischeren Ethylengehalt, so wird der Timer geringer eingestellt als bei unkritischen Werten.

In einer zweckmäßigen Weiterbildung ist vorgesehen, dass die Elektronik einen Verlauf der von dem Sensor ermittelten Daten abspeichert. Damit lässt sich über eine lange Spanne die Produkt- und/oder Verpackungsqualität nachverfolgen. Dies könnte für eventuelle Produkthaftungsfälle als Nachweis herangezogen werden.

Weitere zweckmäßige Weiterbildungen ergeben sich aus weiteren abhängigen Ansprüchen und der Beschreibung.

### Zeichnung

Ausführungsbeispiele der erfindungsgemäßen Vorrichtung zur Öffnungssensierung einer Verpackung sind in der Zeichnung dargestellt und werden nachfolgend näher beschrieben.

Es zeigen:
die Figur 1 eine perspektivische Ansicht einer nicht erfindungsgemäßen Verpackung mit Öffnungssensierung unter Verwendung von Kontaktbahnen,
die Figur 2 eine alternative Ausgestaltung einer nicht erfindungsgemäßen Verpackung mit Öffnungssensierung unter Verwendung von Elektroden,
die Figur 3 eine Ausgestaltung der Verpackung gemäß der Erfindung mit Öffnungssensierung unter Verwendung eines Dehnungssensors,
die Figur 4 eine nicht erfindungsgemäßen Verpackung mit Öffnungssicherung unter Verwendung entsprechender Sensoren,
die Figur 5 eine Verpackung mit integrierter Zeitfunktion,
die Figur 6 eine Verpackung mit integriertem Bedienelement,
die Figuren 7 bis 11 unterschiedliche Herstellungsschritte einer Verpackung mit Öffnungssensierung,
die Figur 12 eine Schaltung bei nicht betätigtem Bedienelement sowie die Figur 13 die Schaltung gemäß Figur 12 bei betätigtem Bedienelement.

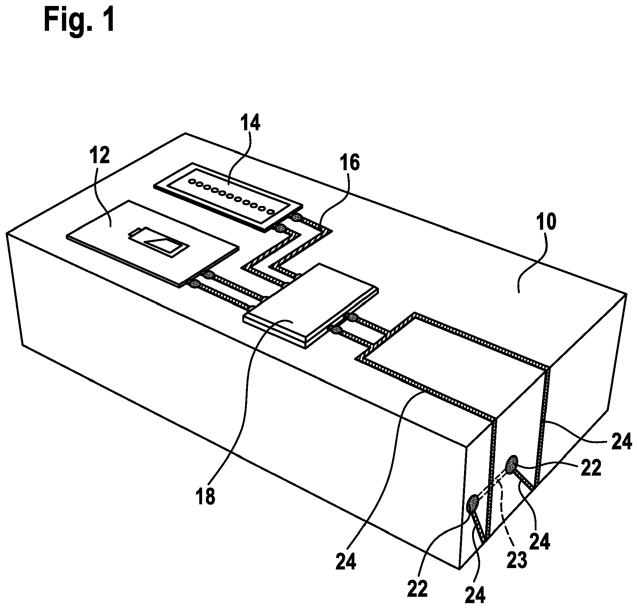

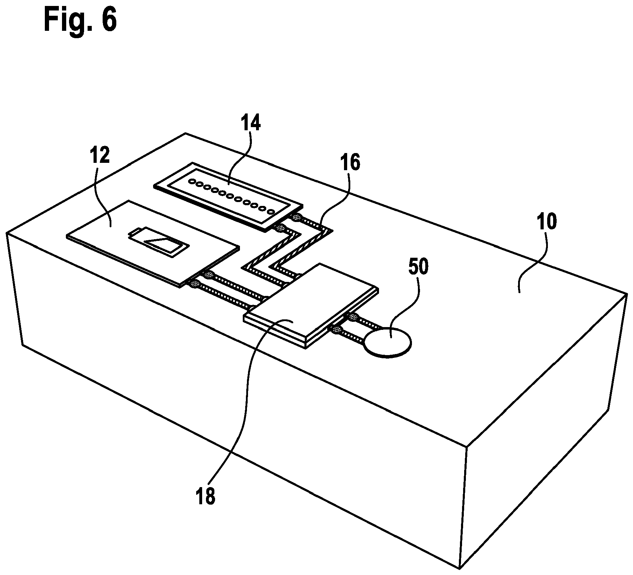

In Figur 1 ist eine Verpackung 10 gezeigt. Auf der Oberseite der Verpackung 10 sind eine Batterie 12, eine Anzeige 14 sowie Kontaktbahnen 16 angeordnet. Die Kontaktbahnen 16 verbinden die Batterie 12 und die Anzeige 14 mit einer Elektronik 18. Auf der der Batterie 12 gegenüberliegenden Seite der Elektronik 18 sind weitere Kontaktbahnen 24, nämlich zwei Kontaktbahnen 24 angeordnet, die in Richtung der Öffnungslasche der Verpackung 10, vorzugsweise eine Faltschachtel, verlaufen. Die zwei Kontaktbahnen 24 laufen jeweils in einem Kontaktpunkt 22 auf. An der Innenseite der Verpackung 10 befindet sich eine parallel zur Öffnungslasche verlaufende weitere Kontaktbahn 23. Im geschlossenen Zustand der Verpackung 10 ist der elektrische Kreis geschlossen. Wird nun die Verpackung 10 auf der mit den Kontaktbahnen 23, 24 versehenen Seite geöffnet, so wird der elektrische Kreis unterbrochen. Dies erkennt die Elektronik 18 und schließt auf ein Öffnen der Verpackung 10. Die Kontaktbahnen 23, 24 dienen also als Mittel zur Öffnungssensierung der Verpackung 10. Hierbei sind die beiden Kontaktbahnen 23, 24 über die Kontaktpunkte 22 so im geschlossenen Zustand der Verpackung 10 verbunden, dass ein elektrischer Stromkreis geschlossen ist. Die ersten Kontaktbahnen 24 befinden sich zusammen mit der Elektronik 18, der Batterie 12 und der Anzeige 14 auf der Oberseite bzw. Außenseite der Verpackung 10 bzw. auf der einen Seite eines Verpackungszuschnitts 11. Die weiteren Kontaktbahn 23 befindet sich auf der gegenüberliegenden Seite des Verpackungszuschnitts 11 bzw. auf der Innenseite der Verpackung 10. Der Verpackungszuschnitt 11 wird so gefaltet, dass die ersten Kontaktbahnen 24 über die stirnseitige Lasche in das Innere der Verpackung 10 ragen und die weitere, innenseitig befindliche Kontaktbahn 23 über die jeweiligen Kontaktpunkte 22 kontaktieren. Weitere Details lassen sich den Figuren 6 bis 10 entnehmen.

Alternativ lässt sich das Mittel zur Öffnungssensierung auch kapazitiv oder auch induktiv realisieren. Wesentlich ist, dass das Öffnen der Verpackung eine sensierbare Änderung einer elektrischen Größe zur Folge hat, die die Elektronik 18 erfassen kann.

Bei der Batterie 12 kann es sich vorzugsweise um eine gedruckte Batterie handeln. Ebenso ist die Anzeige 14 als gedruckte Anzeigemöglichkeit vorzusehen. Ebenfalls die Leiterbahnen 16 sowie die Kontaktbahnen 23, 24, wie auch die Kontaktpunkte 22 können in gedruckter Form vorgesehen werden. Bei der Elektronik 18 handelt es sich um eine konventionelle Schaltung in Form eines Chip, welche auf die Verpackung 10 aufgebracht wird. Alternativ könnte es sich bei der Elektronik 18 auch um eine gedruckte Schaltung handeln.

Wird nun die Öffnungslasche der Verpackung 10 geöffnet, fließt kein Strom mehr über die Kontaktpunkte 22 zu der Kontaktbahn 24, sodass die Elektronik 18 ein Öffnen erkennt. Eine entsprechende Information der geöffneten Verpackung 10 kann beispielsweise über die Anzeige 14 dem Verbraucher signalisiert werden.

In einer alternativen Ausgestaltung können die Kontaktbahnen 23, 24 auch so ausgestaltet sein, dass sie weitere Bereiche der Verpackung 10 sensieren, um ein Öffnen auch an anderen Stellen sicher zu erkennen. In einer alternativen Ausgestaltung könnte die Kontaktbahn 24 auch als Sensorfolie ausgestaltet sein. Alternativ lässt sich das Mittel zur Öffnungssensierung auch kapazitiv oder induktiv realisieren. Wesentlich ist, dass das Öffnen der Verpackung eine sensierbare Änderung einer elektrischen Größe zur Folge hat, die die Elektronik 18 erfassen kann.

Bevorzugt könnte bei einer Sensierung des Öffnens einer Verpackung 10 zumindest ein Impuls generiert wird, den die Elektronik 18 zur Öffnungssensierung auswertet, und/oder über den eine Kapazität geladen wird. Die Elektronik 18 erfasst eine entsprechende Kapazitätsänderung und schließt so auf das Vorliegen des Öffnens der Verpackung 10.

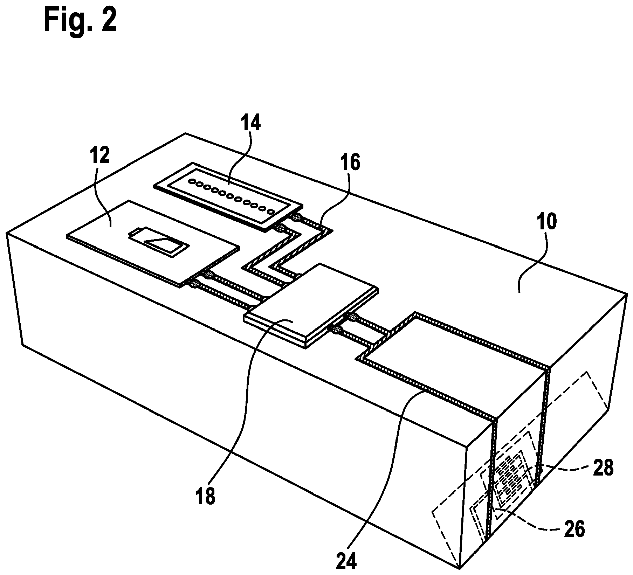

Gemäß Figur 2 erfolgt die Überwachung des Öffnungsvorgangs der Verpackung 10 kapazitiv. Hierzu sind eine erste Elektrode 26 und eine zweite Elektrode 28 vorgesehen. Die eine Elektrode 26 sitzt auf der Innenseite der Verpackung, die andere Elektrode 28 auf der Innenseite der Öffnungslasche. Erste und/oder zweite Elektrode 26, 28 können beispielsweise in Form einer Kammstruktur ausgeführt sein. Die jeweiligen Finger der Kammstrukturen greifen ineinander. Eine Lageveränderung der Elektroden 26, 28 bewirkt eine durch die Elektronik 18 sensierbare Kapazitätsänderung. Somit dienen die Elektroden 26, 28 ebenfalls als Mittel zur Öffnungssensierung der Verpackung 10.

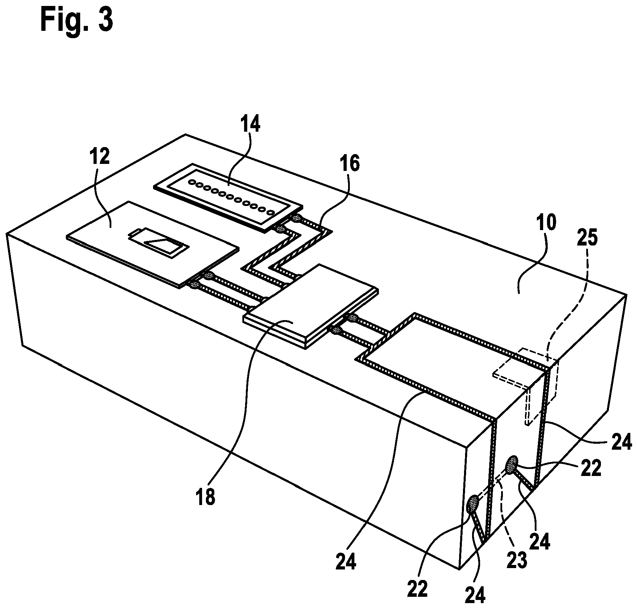

In einer erfindungsgemäßen Ausgestaltung gemäß Figur 3 ist ein Dehnungssensor 25 im Bereich der Kontaktbahnen 24, bevorzugt im Bereich der Lasche um eine Kante der Verpackung 10 gezogen, angeordnet. Damit wird sensiert, wenn eine Dehnung der Lasche durch einen Öffnungsvorgang erzielt wird. Die entsprechende Signaländerung des Dehnungssensors 25 wird durch die Elektronik 18 erfasst und gegebenenfalls zur Anzeige 14 gebracht. Dabei können sowohl der Dehnungssensor 25 wie auch weitere Komponenten (Leiterbahnen 16, Kontaktbahnen 24, Elektronik 18 und Batterie 12 auf der Innenseite der Verpackung 10 angeordnet werden. Dies ist deshalb vorteilhaft, da nun keine besonderen Maßnahmen mehr notwendig sind, diese Komponenten anderweitig zu überdecken. Die Anzeige 14 ist im einfachsten Fall ebenfalls innen angeordnet und ist beispielsweise über eine transparente Folie auch von außen sichtbar. Alternativ erfolgt eine Kontaktierung durch die Verpackung 10 hindurch auf die außen auf der Verpackung 10 sitzende Anzeige 14.

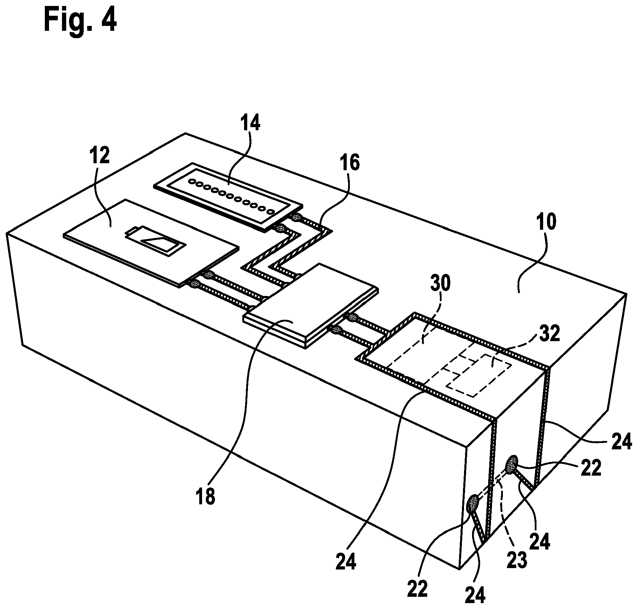

Gemäß Figur 4 sind weitere Komponenten wie zumindest ein Sensor 30 sowie ein Funkmodul 32 vorgesehen.

Bei dem Sensor 30 könnte es sich beispielsweise um einen Temperatursensor handeln. Dieser erfasst die Temperatur der Verpackung 10, um beispielsweise die Temperatur im Inneren der Verpackung auf Einhaltung bestimmter Temperaturprofile zu überwachen. Die erfasste Temperatur könnte hierzu beispielsweise mit einem im Speicher der Elektronik 18 abgelegten Temperaturprofil verglichen werden. Werden bestimmte Grenzwerte überschritten, könnte dies in der Anzeige 14 und/oder über das Funkmodul 32 dem Nutzer mitgeteilt werden. Alternativ könnte als Sensor 30 auch ein Drucksensor vorgesehen werden. Hierbei kann beispielsweise der Luftdruck erfasst werden. So lassen sich entsprechende Soll-Luftdruckprofile überwachen und gegebenenfalls weiterverarbeiten. Dies ist insbesondere bei luftdicht verschlossenen Verpackungen 10 von Interesse, um Aufschluss über das Öffnen der Verpackung 10 bei Abweichungen von einem Solldruck zu erhalten. In einem weiteren alternativen Ausführungsbeispiel ist der Sensor 30 als Erschütterungssensor ausgebildet. Dabei lässt sich überwachen, ob die Verpackung 10 beispielsweise unbeabsichtigt zu Boden ging und gegebenenfalls der Verpackungsinhalt beschädigt wurde. In einer zweckmäßigen Weiterbildung ist als Sensor 30 ein Gassensor vorgesehen. Ein solcher Gassensor ist beispielsweise in der Lage, den Ethylengehalt, beispielsweise zur Erkennung des Reifegrads von Früchten, zu detektieren. Eine entsprechende Auswertung erfolgt in der Elektronik 18, sodass bei Überschreitung eines bestimmten Ethylengehalts eine entsprechende Meldung auf der Anzeige 14 erscheint. Somit können die Sensoren 30 teilweise als Mittel zur Öffnungssensierung einer Verpackung 10 verwendet werden. Bei den Sensoren 30 können gedruckte Sensoren oder konventionell gefertigte zum Einsatz kommen.

Besonders bevorzugt lässt sich der Sensor 30 an der Verpackung 10 zusammen mit weiteren Komponenten wie beispielsweise zumindest ein Funkmodul 32 und/oder zumindest ein Timer 42 und/oder zumindest ein Bedienelement 50 je nach Bedarf anordnen. So kann beispielsweise eine vorteilhafte Kombination erreicht werden, wenn die Elektronik 18 abhängig von einer Betätigung des Bedienelements 50 und/oder eines von dem Funkmodul 32 übertragenen Befehls den Sensor 30 zur Erfassung von Daten ansteuert. Dann kann der Benutzer die aktuellen Daten zum gewünschten Zeitpunkt erhalten beispielsweise bei einer Endkontrolle, bei Anlieferung der mit der Verpackung 10 verpackten Produkte oder vor dem Einräumen im Laden. Die Kontrolle bzw. Sensierung könnte zudem automatisiert werden, indem über das Funkmodul 32 der bzw. die Sensoren 32 aktiviert werden und gegebenenfalls nach Vorverarbeitung der Daten durch die Elektronik 18 zugehörige Meldungen wie Produkt nicht in Ordnung, Verpackung 10 beschädigt, Temperaturverlauf kritisch, zulässiger Druck überschritten, Ethylengehalt kritisch oder ähnliches angezeigt und/oder über das Funkmodul 32 zurückgemeldet werden. Zudem könnten auch nur kritische Zustände zurückgemeldet werden. Hierzu vergleicht die Elektronik 18 die von dem Sensor 30 ermittelten Daten mit einem Grenzwert. Bei Über- oder Unterschreiten des Grenzwerts wird zumindest eine zugehörige Meldung wie oben exemplarisch dargestellt generiert. Bei Über- oder Unterschreiten des Grenzwerts werden die Daten des Sensors 30 und/oder die zugehörige Meldung über die Anzeige 14 und/oder das Funkmodul 32 ausgegeben. Alternativ oder zusätzlich könnte vorgesehen sein, dass die Elektronik 18 bei einem Öffnen der Verpackung 10 und/oder bei Betätigung des Bedienelements 50 und/oder Ablauf des Timers 42 und/oder eines von dem Funkmodul 32 übertragenen Befehls die Daten des Sensors 30 und/oder die zugehörige Meldung über die Anzeige 14 und/oder das Funkmodul 32 ausgibt. Gerade bei Ablauf eines Timers 42 und/oder dem Sensieren eines Öffnens der Verpackung 10 kann automatisch eine Meldung generiert werden und ggf. dem Benutzer zur Anzeige gebracht werden. Alternativ oder zusätzlich könnte vorgesehen sein, dass die Elektronik 18 einen Ablauf des Timers 42 verändert in Abhängigkeit von den vom Sensor 30 ermittelten Daten. Beispielsweise bei höheren Temperaturen ist eine geringere Haltbarkeit des verpackten Produkts zu erwarten, so dass der Timer 42 mit einer geringeren Zeitspanne gestartet wird. Oder erfasst der Sensor 30 bereits einen erhöhten bzw. kritischeren Ethylengehalt, so wird der Timer 42 geringer eingestellt als bei unkritischen Werten. Damit wird produkt- bzw. verpackungsindividuell eine spezielle Überwachung ermöglicht. Alternativ oder zusätzlich speichert die Elektronik 18 einen Verlauf der von dem Sensor 30 ermittelten Daten ab. Damit lässt sich über eine lange Spanne die Produkt- und/oder Verpackungsqualität nachverfolgen. Dies könnte für eventuelle Produkthaftungsfälle als Nachweis herangezogen werden. Weiterhin könnte nur ein Sensor 30 oder aber weitere Sensoren 30 vorgesehen werden.

Bei dem Funkmodul 32 könnte es sich beispielsweise um eine Transpondertechnologie handeln wie RFID, WLAN, Bluetooth, NFC (near field communication). Das Funkmodul 32 sendet entsprechende Daten an eine von der Verpackung 10 entfernt angeordnete Auswerteeinheit. Hierbei kann es sich um Daten handeln, die von dem Sensor 30 erfasst und ggf. von der Elektronik 18 aufbereitet wurden. Auch könnte die Ermittlung eines Öffnens der Verpackung 10, die Zeit des Öffnens und/oder der Ablauf eines Timers 42 wie nachfolgend beschrieben gesendet werden. Auch das Funkmodul 32 könnte gedruckt oder konventionell realisiert werden.

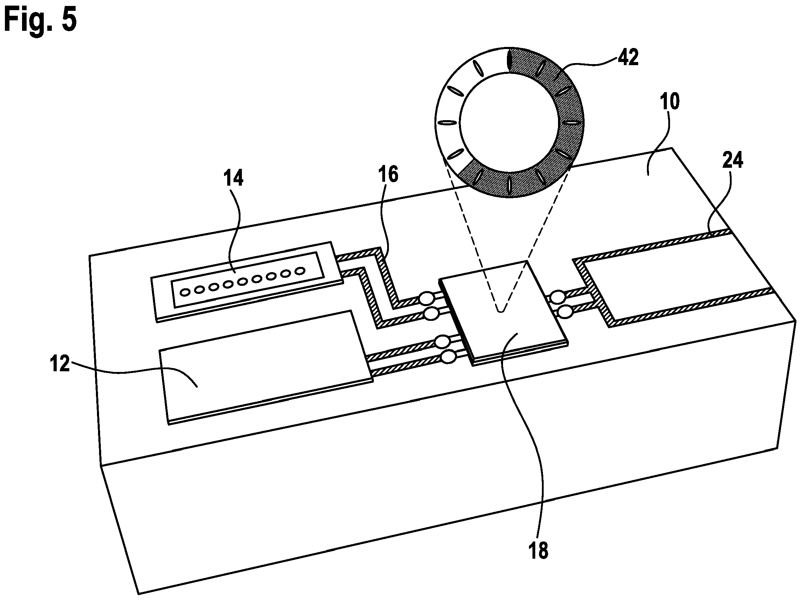

In einem alternativen Ausführungsbeispiel gemäß Figur 5 ist in der Elektronik 18 ein Timer 42 vorgesehen. Die Elektronik 18 detektiert das Öffnen der Verpackung 10 und startet den Timer 42. Ist ein bestimmtes Zeitintervall überschritten, folgt eine entsprechende Meldung wie beispielsweise der Ablauf des verpackten Produkts. Alternativ oder zusätzlich speichert die Elektronik 18 bei Ablauf des Timers 42 eine bestimmte Information, vorzugsweise betreffend einem in der Verpackung 10 befindlichen Produkt, ab.

Alternativ könnten auch mehrere Timer 42 vorgesehen sein, bei deren Ablauf unterschiedliche Informationen, insbesondere betreffend eines in der Verpackung 10 befindlichen Produkts, zur Anzeige 14 gelangen und/oder abgespeichert werden und/oder über das Funkmodul 32 gesendet werden können.

Bei einem alternativen Ausführungsbeispiel gemäß Figur 6 ist neben der Batterie 12, der Anzeige 14, den Leiterbahnen 16 und der Elektronik 18 zumindest ein Bedienelement 50 vorgesehen. Alternativ könnten auch mehrere Bedienelemente 50 vorgesehen sein. Das Bedienelement 50 ist an der Außenseite der Verpackung 10 angeordnet. Ein Benutzer kann dieses betätigen. Die Elektronik 18 erkennt eine Betätigung beispielsweise durch Veränderung elektrischer Größen. In der Elektronik 18 befindet sich ein Speicher, in dem die dann zur Anzeige 18 zu bringenden Daten abgespeichert sind. Hierbei wäre es denkbar, die Anzeige 14 zu aktivieren, oder mit jedem weiteren Betätigen weiterzuschalten und unterschiedliche Informationen zur Anzeige 18 zu bringen. Alternativ können auch weitere, in den vorangegangenen Ausführungsbeispielen beschriebene Komponenten vorgesehen werden. Insbesondere könnten Mittel zur Öffnungssensierung 23, 24, 25, 26, 28 vorgesehen werden und/oder das Funkmodul 32 und/oder ein oder mehrere Sensoren 30 zur Ermittlung einer Temperatur und/oder eines Drucks bzw. Luftdrucks und/oder einer Beschleunigung und/oder einer Erschütterung und/oder eines Gases.

Besonders bevorzugt kann die Elektronik 18 auch so ausgestattet sein, dass diese die Dauer einer oder mehrerer Betätigung(en) des Bedienelements 50 erkennt. Abhängig von der jeweiligen Betätigung und/oder der Dauer der jeweiligen Betätigung sind in der Elektronik unterschiedliche Datensätze oder auch Ansteuerungen hinterlegt.

So steuert die Elektronik 18 abhängig von der Betätigung des Bedienelements 50 die Anzeige 14 und/oder das Funkmodul 32 und/oder einen Speicher und/oder den Timer 42 und/oder den Sensor 30 zur Erfassung von Sensordaten an. So wäre beispielsweise denkbar, dass bei Betätigung des Bedienelements 50 eine andere Information betreffend des in der Verpackung 10 befindlichen Produkts angezeigt wird, beispielsweise eine andere Sprache, eine andere Information wie Mindesthaltbarkeit, Inhaltsstoffe oder aber auch für die Logistik interessierende Daten wie Anlieferung, Einlagerung, Herkunft, Transport, Sicherheitscode oder ähnliches. Alternativ oder zusätzlich könnten solche Informationen auch über das Funkmodul 32 weitergegeben werden.

Abhängig von der Betätigung des Bedienelements 50 könnte auch ein Timer 42 gestartet werden beispielsweise zur zeitlich begrenzten Anzeige einer Information bzw. nach Ablauf des Timers 42 könnte eine andere Information automatisch zur Anzeige gelangen. Hierbei könnte es sich beispielsweise um eine Preisinformation handeln, die nach Ablauf einer bestimmten Zeitspanne beispielsweise vor Ablauf der Mindesthaltbarkeit verändert wird und so automatisch zu Aktionsware wird.

Alternativ könnte auch bei Betätigung des Bedienelements 50 die Elektronik 18 gerade aktuelle Daten des Sensors 30 abfragen und zur Anzeige 14 bringen und/oder über das Funkmodul 32 ausgegeben und/oder in der Elektronik 18 abspeichern. Hierbei könnten die Sensordaten erfasst und auch in der Elektronik 18 weiterverarbeitet werden, wenn diese mit hinterlegten Grenzwerten verglichen werden und je nach Überschreiten entsprechende Informationen ausgegeben werden, sei es über die Anzeige 14 und/oder das Funkmodul 32.

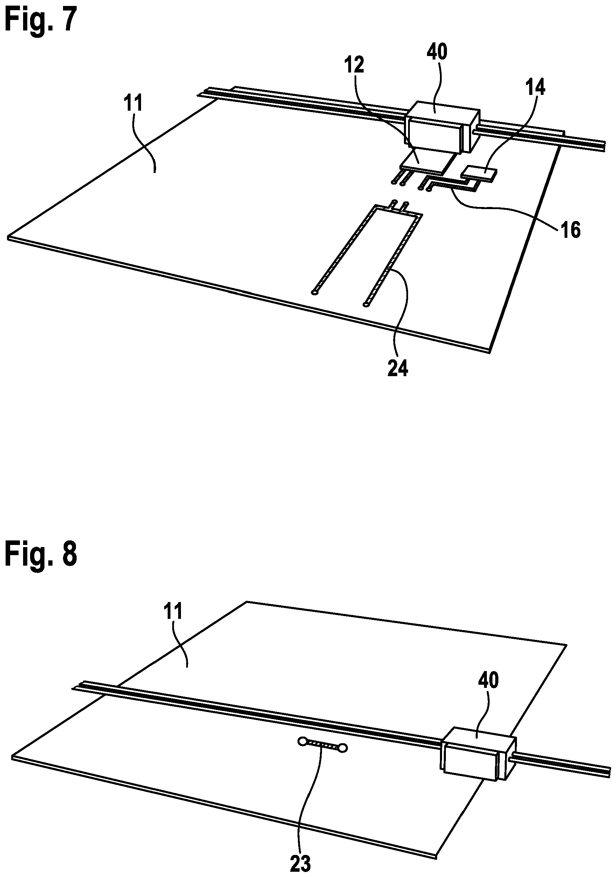

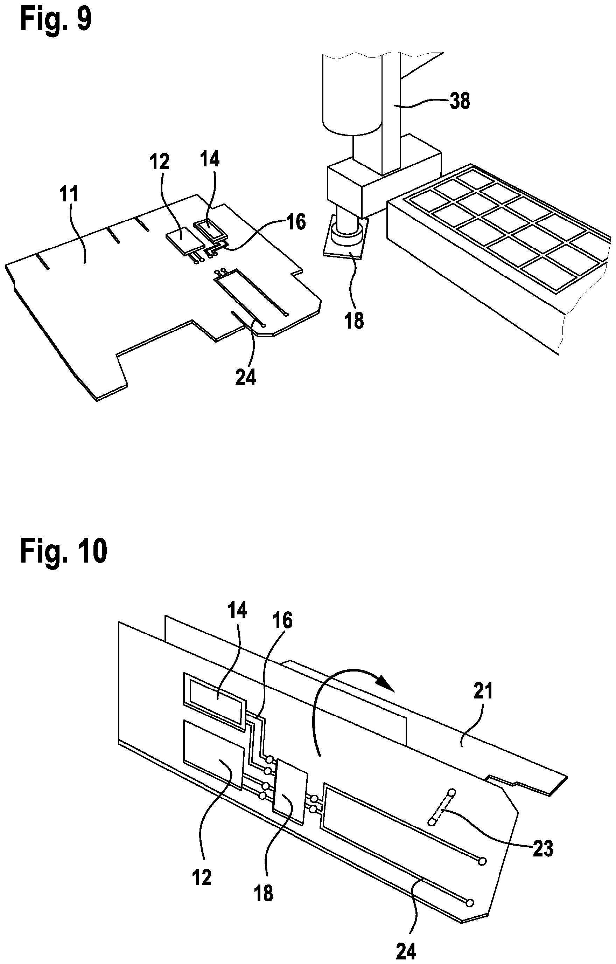

In den Figuren 7 bis 10 werden unterschiedliche Schritte der Herstellung einer Verpackung mit den Komponenten des Ausführungsbeispiels gemäß Figur 1 gezeigt. Prinzipiell lassen sich diese Herstellungsschritte auch auf die anderen Ausführungsbeispiele übertragen. Der Verpackungszuschnitt 11 für die Verpackung 10 befindet sich im planen Zustand. Ein Druckkopf 40 bringt gemäß Figur 7 nacheinander (zeilenweise) die Leiterbahnen 16, die Anzeige 14 sowie die Batterie 12 und die Kontaktbahnen 24 (nicht gezeigt) auf. Anschließend wird der Verpackungszuschnitt 21 auf die andere Seite gedreht. Dort wird die Kontaktbahn 23 aufgedruckt (Figur 8). Anschließend wird der Verpackungszuschnitt 11 ausgestanzt für die spätere Faltung zu einer Faltschachtel. In einem weiteren Verfahrensschritt wird die Elektronik 18 aufgebracht (Figur 9). Hierzu ist ein entsprechendes Handhabungsgerät 38 wie beispielsweise ein Roboter vorzusehen, der die Elektronik 18 an die entsprechende Stelle des Zuschnitts 11 platziert und befestigt. Der ausgestanzte Zuschnitt 11 wird gefaltet zu einer Faltschachtel wie der Pfeil symbolisiert. Hierbei kommen die Kontaktpunkte 22 der Kontaktbahnen 24 mit denjenigen der weiteren Kontaktbahn 23 in elektrisch leitendem Kontakt.

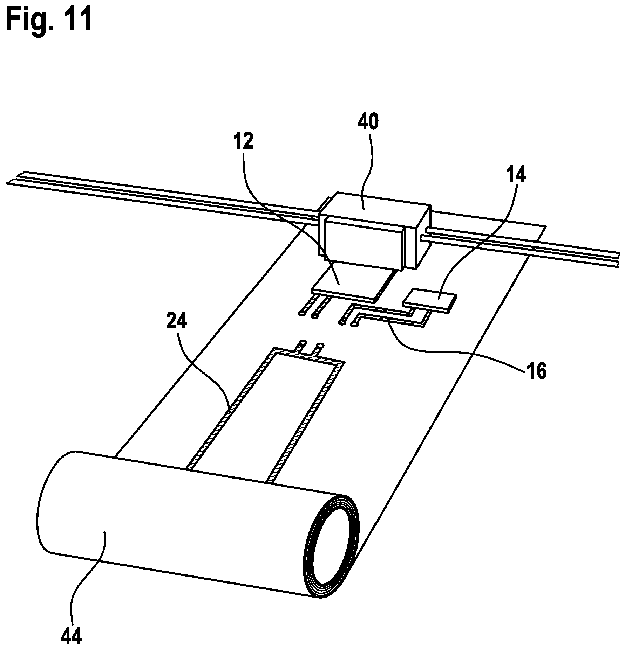

In einer alternativen Fertigungsvariante werden die Komponenten Batterie 12, Anzeige 14, Leiterbahnen 16 auf eine Folie 44 aufgedruckt (Figur 11). Wiederum wird die Elektronik 18 auf der Folie 44 aufgebracht und befestigt. Die so entsprechend vorbereitete Folie 44 wird mit dem Verpackungszuschnitt 11 verbunden. In einem letzten Schritt werden diejenigen Komponenten überdruckt, die für den Verbraucher nicht sichtbar sein sollen wie beispielsweise die Batterie 12, die Leiterbahnen 16, die Elektronik 18 sowie die Kontaktbahnen 24. Lediglich die Anzeige 14 bleibt sichtbar.

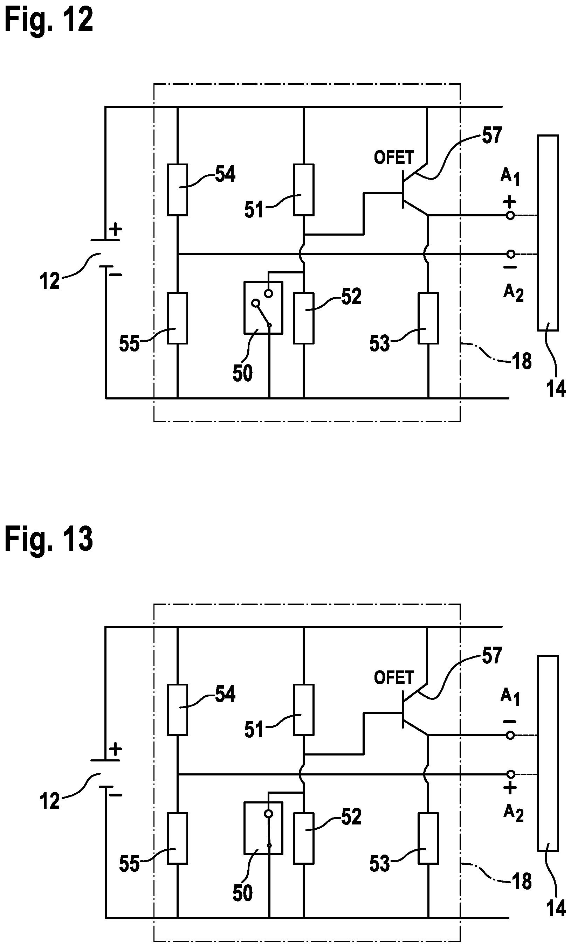

Eine elegante Lösung für einen Schaltvorgang der Anzeige 14 erfolgt unter Verwendung eines Druckknopfs als Beispiel für ein Bedienelement 50. Für eine entsprechende Schaltung sind fünf Widerstände 51-55 und ein Schaltmittel wie beispielsweise ein OFET vorgesehen. Bei der Schaltung gemäß den Figuren 12 und 13 kann die Anzeige 14 mit einem Pluspol der Batterie 12 über ein Schaltmittel 57 verbunden werden. Der andere Ausgang des Schaltmittels 57 ist über einen dritten Widerstand 53 mit einem Minuspol der Batterie 12 verbunden. Der negative Anschluss der Anzeige 14 ist über einen aus einem vierten Widerstand 54 und einem fünften Widerstand 55 gebildeten Spannungsteiler mit der Batterie 12 verbunden. Ein erster Widerstand 51 ist mit dem Pluspol der Batterie 12 verbunden, dessen anderer Anschluss ist sowohl mit einem Steuereingang des Schaltmittels 57 wie auch mit einem Anschluss eines zweiten Widerstands 52 verbunden. Ein anderer Anschluss des zweiten Widerstands 52 liegt auf dem Minuspotential der Batterie 12. Parallel zum zweiten Widerstand 52 ist das Bedienelement 50 verschaltet.

Der Anzeigenwechsel kann mit dem Schaltplan gemäß den Figuren 12 und 13 realisiert werden. Wird das Bedienelement 50 wie ein Foliendruckknopf nicht betätigt, so fließt der Steuerstrom des Schaltmittels 57 über den ersten Widerstand 51 zum Schaltmittel 57, im Ausführungsbeispiel ein Transistor. Das Schaltmittel 57 schaltet und lässt über seine Source-Drain-Verbindung den elektrischen Strom fließen. An dem einen Anschluss A1 der Anzeige 12 liegt ein positiver Versorgungsstrom an. Wird das Bedienelement 50, der Foliendruckkopf, anschließend betätigt, so ist das Schaltmittel 57 geöffnet, der Transistor also gesperrt und der Steuerstrom fließt direkt über den ersten Widerstand 51 und das Bedienelement 50 zurück zur Batterie. Somit liegt am Anschluss A1 der Anzeige 14 ein negativer Versorgungsstrom an. Eingesetzt werden kann dieses Konzept für alle denkbaren Verpackungsarten, die genügend Raum für eine Batterie 12, und eine Anzeige 14 aufweisen.

Als Verpackung 10 könnte es sich beispielsweise um Faltschachteln, Schlauchbeutel, Flaschen, tiefgezogene Plastikbehältnisse (Becher, Trays, Blister) oder sonstige Behältnisse handeln.

## Patentansprüche

1. Vorrichtung zur Öffnungssensierung einer Verpackung, umfassend zumindest eine Verpackung (10), zumindest eine Elektronik (18), zumindest eine Batterie (12), die die Elektronik (18) mit Energie versorgt, zumindest eine Anzeige (14), die von der Elektronik (18) ansteuerbar ist, und zumindest ein Mittel (23, 24, 25, 26, 28) zur Öffnungssensierung der Verpackung (10), wobei die Elektronik (18), die Batterie (12), die Anzeige (14) und das Mittel (23, 24, 25, 26, 28) zur Öffnungssensierung an einer Verpackung (10) angeordnet sind, **dadurch gekennzeichnet, dass** als Mittel zur Öffnungssensierung der Verpackung (10) zumindest ein Dehnungssensor (25) vorgesehen ist.

2. Vorrichtung nach Anspruch 1, **dadurch gekennzeichnet, dass** das Mittel zur Öffnungssensierung (23, 24, 25, 26, 28) und/oder die Batterie (12) und/oder die Anzeige (14) und/oder zumindest eine Leiterbahn (16) aufgedruckt ist auf einem Trägermaterial wie einem Verpackungszuschnitt (11) und/oder einer Folie (44) als Bestandteil der Verpackung (10).

3. Vorrichtung nach einem der vorhergehenden Ansprüche, **dadurch gekennzeichnet, dass** bei einer Öffnungssensierung einer Verpackung (10) zumindest ein Impuls generiert wird, den die Elektronik (18) zur Öffnungssensierung auswertet, und/oder über den eine Kapazität geladen wird.

4. Vorrichtung nach einem der vorhergehenden Ansprüche, **dadurch gekennzeichnet, dass** die Mittel zur Öffnungssensierung (23, 24, 25, 26, 28) und/oder die Elektronik (18) auf der Innenseite der Verpackung (10) aufgebracht sind.

5. Vorrichtung nach einem der vorhergehenden Ansprüche, **dadurch gekennzeichnet, dass** abhängig von einer Öffnungssensierung der Verpackung (10) ein Timer (42) und/oder die Anzeige (14) und/oder eine Erfassung einer Information eines Sensors (30) und/oder ein Funkmodul (32) aktiviert ist.

6. Vorrichtung nach einem der vorhergehenden Ansprüche, **dadurch gekennzeichnet, dass** zumindest ein Bedienelement (50) vorgesehen ist zur Beeinflussung der Anzeige (14) und/oder zumindest eines Funkmoduls (32) und/oder zumindest eines Timers (42) und/oder zumindest eines Sensors (30) zur Ermittlung einer Temperatur und/oder eines Drucks, insbesondere Luftdrucks, und/oder einer Beschleunigung und/oder einer Erschütterung und/oder eines Gases.

7. Vorrichtung nach einem der vorhergehenden Ansprüche, **dadurch gekennzeichnet, dass** das Mittel zur Öffnungssensierung (23, 24, 25, 26, 28) in einem Öffnungsbereich, vorzugsweise im Bereich einer Öffnungslasche, der Verpackung (10) angeordnet ist.

8. Verfahren zur Herstellung einer Vorrichtung nach einem der vorhergehenden Ansprüche, **gekennzeichnet durch** folgende Schritte:
Bedrucken eines Trägermaterials wie ein Verpackungszuschnitt (11) und/oder eine Folie (44) mit zumindest einer Leiterbahn (16) und/oder zumindest einem Energiespeicher wie eine Batterie (12) und/oder zumindest einer Anzeige (14),
Aufbringen zumindest eines Mittels (23, 24, 25, 26) zur Öffnungssensierung auf das Trägermaterial (11, 44), wobei als Mittel zur Öffnungssensierung zumindest ein Dehnungssensor (25) vorgesehen ist.

9. Verfahren nach dem vorhergehenden Verfahrensanspruch, **dadurch gekennzeichnet, dass** zumindest eine Elektronik (18) und/oder ein Sensor (30) und/oder ein Funkmodul (24) vorzugsweise von einer Handhabungseinheit (38) auf das Trägermaterial (11, 44) aufgebracht werden.

10. Verfahren nach einem der vorhergehenden Verfahrensansprüche, **dadurch gekennzeichnet, dass** das Trägermaterial (11, 44) zumindest als Teil eines Verpackungsmaterials zu einer Verpackung (10) geformt wird.

11. Verfahren nach einem der vorhergehenden Verfahrensansprüche, **dadurch gekennzeichnet, dass** das Trägermaterial (44), vorzugsweise eine Folie, mit einem Verpackungsmaterial verbunden wird.

## Claims

1. Device for sensing whether a package has been opened, comprising at least one package (10), at least one electronics system (18), at least one battery (12) which supplies energy to the electronics system (18), at least one display (14) which can be actuated by the electronics system (18), and at least one means (23, 24, 25, 26, 28) for sensing whether the package (10) has been opened, wherein the electronics system (18), the battery (12), the display (14) and the means (23, 24, 25, 26, 28) for sensing whether a package has been opened are arranged on a package (10), **characterized in that** at least one strain sensor (25) is provided as means for sensing whether the package (10) has been opened.

2. Device according to Claim 1, **characterized in that** the means (23, 24, 25, 26, 28) for sensing whether a package has been opened and/or the battery (12) and/or the display (14) and/or at least one conductor track (16) are/is printed on a carrier material such as a package blank (11) and/or a film/foil (44) as a constituent part of the package (10).

3. Device according to one of the preceding claims, **characterized in that**, when it is sensed that a package (10) has been opened, at least one pulse is generated, the electronics system (18) evaluates said pulse for sensing whether the package has been opened, and/or a capacitor is charged by means of said pulse.

4. Device according to one of the preceding claims, **characterized in that** the means (23, 24, 25, 26, 28) for sensing whether a package has been opened and/or the electronics system (18) are fitted on the inside of the package (10).

5. Device according to one of the preceding claims, **characterized in that** a timer (42) and/or the display (14) and/or detection of an item of information from a sensor (30) and/or a radio module (32) are/is activated depending on opening of the package (10) being sensed.

6. Device according to one of the preceding claims, **characterized in that** at least one operator control element (50) is provided for influencing the display (14) and/or at least one radio module (32) and/or at least one timer (42) and/or at least one sensor (30) for determining a temperature and/or a pressure, in particular atmospheric pressure, and/or acceleration and/or vibration and/or a gas.

7. Device according to one of the preceding claims, **characterized in that** the means (23, 24, 25, 26, 28) for sensing whether a package has been opened is arranged in an opening region, preferably in the region of an opening tab, of the package (10).

8. Method for producing a device according to one of the preceding claims, **characterized by** the following steps:
printing a carrier material, such as a package blank (11) and/or a film/foil (44), with at least one conductor track (16) and/or at least one energy store, such as a battery (12), and/or at least one display (14),
fitting at least one means (23, 24, 25, 26) for sensing whether a package has been opened onto the carrier material (11, 44), wherein at least one strain sensor (25) is provided as means for sensing whether the package has been opened.

9. Method according to the preceding method claim, **characterized in that** at least one electronics system (18) and/or a sensor (30) and/or a radio module (24) are fitted onto the carrier material (11, 44), preferably by a handling unit (38).

10. Method according to one of the preceding method claims, **characterized in that** the carrier material (11, 44) is formed at least as part of a package material for forming a package (10).

11. Method according to one of the preceding method claims, **characterized in that** the carrier material (44), preferably a film/foil, is connected to a package material.

## Revendications

1. Dispositif, destiné à détecter l'ouverture d'un emballage, comprenant au moins un emballage (10), au moins une électronique (18), au moins une batterie (12) qui alimente l'électronique (18) en énergie, au moins un système d'affichage (14), susceptible d'être activé par l'électronique (18) et au moins un moyen (23, 24, 25, 26, 28) pour détecter l'ouverture de l'emballage (10), l'électronique (18), la batterie (12), le système d'affichage (14) et le moyen (23, 24, 25, 26, 28) étant placés sur un emballage (10) pour la détection d'ouverture, **caractérisé en ce qu'**il est prévu au moins un capteur de contraintes (25) en tant que moyen pour la détection d'ouverture de l'emballage (10).

2. Dispositif selon la revendication 1, **caractérisé en ce que** le moyen de détection d'ouverture (23, 24, 25, 26, 28) et/ou la batterie (12) et/ou le système d'affichage (14) et/ou au moins une piste conductrice (16) est imprimé(e) sur une matière de support, telle qu'un coupon d'emballage (11) et/ou un film (44) en tant que partie intégrante de l'emballage (10).

3. Dispositif selon l'une quelconque des revendications précédentes, **caractérisé en ce que** lors d'une détection d'ouverture d'un emballage (10), il est généré au moins une impulsion que l'électronique (18) de détection d'ouverture évalue et/ou par l'intermédiaire de laquelle une capacité est chargée.

4. Dispositif selon l'une quelconque des revendications précédentes, **caractérisé en ce que** le moyen de détection d'ouverture (23, 24, 25, 26, 28) et/ou l'électronique (18) est monté(e) sur la face intérieure de l'emballage (10).

5. Dispositif selon l'une quelconque des revendications précédentes, **caractérisé en ce qu'**en fonction d'une détection d'ouverture d'un emballage (10), une minuterie (42) et/ou le système d'affichage (14) et/ou une détection d'une information d'un capteur (30) et/ou un module radio (32) sont activés.

6. Dispositif selon l'une quelconque des revendications précédentes, **caractérisé en ce qu'**il est prévu au moins un élément de commande (50) pour influencer le système d'affichage (14) et/ou au moins un module radio (32) et/ou au moins une minuterie (42) et/ou au moins un capteur (30) destinés à déterminer une température et/ou une pression, notamment une pression atmosphérique, et/ou une accélération et/ou une secousse et/ou un gaz.

7. Dispositif selon l'une quelconque des revendications précédentes, **caractérisé en ce que** le moyen de détection d'ouverture (23, 24, 25, 26, 28) est placé dans une zone d'ouverture, de préférence dans la zone d'une patte d'ouverture de l'emballage (10).

8. Procédé, destiné à fabriquer un dispositif selon l'une quelconque des revendications précédentes, **caractérisé par** les étapes suivantes, consistant à :
imprimer une matière de support, tel qu'un coupon d'emballage (11) et/ou un film (44) avec au moins une piste conductrice (16) et/ou au moins un accumulateur d'énergie, comme une batterie (12) et/ou au moins un système d'affichage (14),
appliquer au moins un moyen (23, 24, 25, 26) de détection d'ouverture sur la matière de support (11, 44), en tant que moyen de détection d'ouverture étant prévu au moins un capteur de contraintes (25).

9. Procédé selon la revendication de procédé précédente, **caractérisé en ce qu'**au moins une électronique (18) et/ou un capteur (30) et/ou un module radio (24) sont appliqués de préférence par une unité de manipulation (38) sur la matière de support (11, 44).

10. Procédé selon l'une quelconque des revendications de procédé précédentes, **caractérisé en ce que** la matière de support (11, 44) est façonnée en un emballage (10), au moins en tant que partie intégrante d'une matière d'emballage.

11. Procédé selon l'une quelconque des revendications de procédé précédentes, **caractérisé en ce que** la matière de support (44), de préférence un film est reliée avec une matière d'emballage.
